# EUROPÄISCHE PATENTSCHRIFT

(11) **EP 2 807 909 B1**
(45) Veröffentlichungstag und Bekanntmachung des Hinweises auf die Patenterteilung: **13.11.2024**
(21) Anmeldenummer: 13703989.7
(22) Anmeldetag: 09.01.2013
(51) Int. Cl.: H05K 7/20

(54) **SCHALTSCHRANK MIT GEHÄUSE**
ELECTRICAL CABINET WITH HOUSING
ARMOIRE DE COMMANDE AVEC BOÎTIER

(30) Priorität: 23.01.2012 DE 102012001119
(43) Veröffentlichungstag der Anmeldung: 03.12.2014
(73) Patentinhaber: SEW-EURODRIVE GmbH & Co. KG, 76646 Bruchsal (DE)
(72) Erfinder: SCHWESINGER, Klaus, 76646 Bruchsal (DE); SCHMIDT, Josef, 76676 Graben-Neudorf (DE)
(86) Internationale Anmeldenummer: PCT/EP2013/000038
(87) Internationale Veröffentlichungsnummer: WO 2013/110431

(56) Entgegenhaltungen:
- WO-A1-2005/048672
- DE-A1- 102004 030 675
- DE-A1- 102007 038 676
- DE-A1- 102010 045 022
- DE-U1- 8 509 176
- JP-A- 2005 142 379
- US-A1- 2005 286 226
- US-B2- 7 148 452

## Beschreibung

Die Erfindung betrifft ein Schaltschrank, mit Gehäuse.

Es ist allgemein bekannt, Elektrogeräte, die Wärme erzeugende Bauelemente aufweisen, in Schaltschränken einzumontieren, insbesondere an Hutschienen.

**Aus der** WO 2005/048672 A1 **ist ein Netzversorgungsmodul mit verbesserter Kühlung bekannt.**

**Aus der** US 2005/286226 A1 **ist eine Wärme erzeugende Komponente mit Kühlstruktur bekannt.**

**Aus der** DE 10 2010 045022 A1 **ist als nächstliegender Stand der Technik ein Schaltschrank bekannt.**

**Aus der** JP 2005 142379 A **ist ein Elektrogerät bekannt.**

**Aus der** DE 10 2004 030675 A1 **ist eine Kühleinrichtung für elektronische Bauelemente bekannt.**

**Aus der** DE 85 09 176 U1 **ist ein Luftwärmetauscher zum Kühlen von Bauelementen der Leistungselektronik bekannt.**

**Aus der** US 7 148 452 B2 **ist eine Wärmesenke für Leiterplatten bekannt.**

**Aus der** DE 10 2007 038676 A1 **ist ein Elektrogerät mit einem flexiblen Bereich aufweisender Leiterplatte bekannt.**

Der Erfindung liegt daher die Aufgabe zugrunde, eine verbesserte Entwärmung vorzusehen.

Erfindungsgemäß wird die Aufgabe bei der Vorrichtung nach den in Anspruch 1 angegebenen Merkmalen gelöst.

Wichtige Merkmale der Erfindung bei der Vorrichtung, insbesondere Schaltschrank, mit Gehäuse, sind, dass
das Gehäuse ein oder mehrere Module gehäusebildend umgibt und zumindest ein Luftleitteil umfasst,
**wobei** das beziehungsweise jedes Modul zentral belüftet ist, insbesondere also einen von einem Kühlmedium durchströmten, im Modul angeordneten Kühlkanal aufweist,
wobei die zentrale Belüftung, insbesondere der Kühlkanal, des oder jedes Moduls in einen innerhalb des Gehäuses angeordneten Sammelkanal, insbesondere Luftkanal, mündet,
wobei der Sammelkanal zu einem Luftleitteil, insbesondere Umlenkteil, des Gehäuses führt, wobei das Luftleitteil eine zur Umgebung hin gerichtete Öffnung aufweist.

Von Vorteil ist dabei, dass durch die Vielzahl von Modulen eine große entwärmte Oberfläche realisierbar ist und durch die zentrale Belüftung ebenfalls eine große Entwärmung realisierbar ist. Denn die zentrale Belüftung ermöglicht ein um den zugehörigen Kühlkanal herumgehendes Anordnen von zu entwärmenden Bauelementen. Die Bauelemente müssen also nicht in einer geraden Linie angeordnet werden sondern entlang einer gekrümmten Linie oder Fläche, die den Kühlkörper beziehungsweise dessen Kühlkanal zumindest teilweise umschließt.

Bei einer vorteilhaften Ausgestaltung erfolgt die Speisung der zentralen Belüftung aus einem von dem Gehäuse umgebenen Innenbereich der Vorrichtung. Von Vorteil ist dabei, dass ein druckausgleichender Innenbereich zum Speisen mehrerer gegebenenfalls unterschiedlich stark ansaugender zentraler Belüftungen verwendet wird. Somit sind also Lüfter bei den Modulen einsetzbar, deren Leistung von der jeweils benötigten beziehungsweise prognostizierten Leistung variiert. Hierbei hängt der Kühlluftstrom von der Leistung des Lüfters ab. Durch den großen Innenbereich der Vorrichtung ist ein Druckpuffer realisierbar.

Bei einer vorteilhaften Ausgestaltung weist das Gehäuse eine Ausnehmung auf, durch welche der Innenbereich mit einem Kühlmediumstrom speisbar ist,
insbesondere wobei in der Ausnehmung des Gehäuses ein Lüftergitter angeordnet ist. Von Vorteil ist dabei, dass nur eine einzige Ausnehmung durch ein Lüftergitter geschützt werden muss. Das Lüftergitter ist auch derart feinmaschig ausführbar, dass eine Filterung des Kühlluftstroms ausführbar ist, also entsprechend zu große Schmutzpartikel herausfilterbar sind aus dem Kühlluftstrom.

Bei einer vorteilhaften Ausgestaltung ist innerhalb des Gehäuses zwischen Innenbereich und Sammelkanal eine Montageplatte angeordnet,
insbesondere wobei der Innenbereich mittels einer Montageplatte vom Sammelkanal abgegrenzt ist. Von Vorteil ist dabei, dass eine Trennung der kühleren Luftbereiche von den wärmeren Abluftbereichen erreicht ist und somit eine effektivere Kühlung ausführbar ist.

Bei einer vorteilhaften Ausgestaltung sind die Module mit der Montageplatte verbunden, insbesondere von der Montageplatte gehalten sind, insbesondere schraubverbunden sind. Von Vorteil ist dabei, dass die die kühleren von den wärmeren Bereichen trennende Montageplatte auch als mechanische Haltevorrichtung fungiert.

Bei einer vorteilhaften Ausgestaltung ist das Luftleitteil als Stranggussteil gefertigt. Von Vorteil ist dabei, dass eine kostengünstige Herstellung ermöglicht ist, insbesondere aus Aluminium, welches einen geringen Wärmeleitwiderstand aufweist.

Bei einer vorteilhaften Ausgestaltung weist das Luftleitteil eine Grundplatte auf, an welcher dem Innenraum der Vorrichtung zugewandte Kühlrippen angeordnet sind,
insbesondere so, dass der aus dem Sammelkanal ausströmende Kühlmediumstrom an den Kühlrippen entlang in die Umgebung herausgeleitet wird,
insbesondere wobei hierbei der Kühlmediumstrom umgelenkt wird, insbesondere von einer im Wesentlichen vertikalen in eine im Wesentlichen horizontale Richtung. Von Vorteil ist dabei, dass durch die Umlenkung ein geradliniges Eindringen von Schmutzpartikeln oder Flüssigkeiten verhinderbar ist, insbesondere auch bei ausgeschalteter Vorrichtung. Somit ist ein verbesserter Schutz für den Gehäuseinnenbereich erreicht. Außerdem muss das Kühlmedium dem Umlenkbereich des Umlenkteils folgen und strömt somit entlang einer großen Oberfläche bei geringem Bauvolumen des Umlenkteils. Insgesamt ist somit die Vorrichtung sehr kompakt ausführbar.

Bei einer vorteilhaften Ausgestaltung weist die Montageplatte eine dem jeweiligen Modul, insbesondere dessen zentraler Belüftung und/oder dessen Kühlkanal, zugeordnete, durch die Montageplatte durchgehende Ausnehmung auf, insbesondere zur Durchströmung mittels des Kühlmediumstroms. Von Vorteil ist dabei, dass eine Vielzahl von Modulen an der Montageplatte anordenbar ist. Somit sind sogar gleichartig ausgeführte Module einsetzbar, deren Ausgangsströme oder Ausgangsspannungen parallel schaltbar sind, so dass eine größere Leistung erzeugbar ist gemäß dem modulartigen Aufbau. Denn der Nutzer wählt die Anzahl der Module entsprechend der benötigten Leistung.

Es ist sogar eine Montageplatte mit einer größeren Anzahl von Ausnehmungen herstellbar als die Anzahl der eingesetzten Module. Auf diese Weise ist bei verschieden großen Leistungen, also einer verschiedenen Anzahl von Modulen, stets dieselbe Montageplatte verwendbar. Die nicht durch Module abgedeckten Ausnehmungen sind mit einem Verschließteil verschließbar, so dass die Trennfunktion zwischen kühlerer und wärmerer Luft erhalten bleibt.

Bei einer vorteilhaften Ausgestaltung ist der Innenbereich durch zumindest die Montageplatte, das Gehäuse und das Lüftergitter begrenzt
und/oder
der Sammelkanal ist durch zumindest die Montageplatte und das Gehäuse begrenzt. Von Vorteil ist dabei, dass eine einfache Abtrennung des Innenbereichs mit kühlerer Luft von dem Sammelkanal mit wärmerer Luft erreichbar ist.

Bei einer vorteilhaften Ausgestaltung weist das Modul einen Kühlkörper mit einem durchgehenden Hohlraum auf, welcher als Kühlkanal fungiert,
insbesondere wobei der Kühlkörper als Stranggussteil ausgeführt ist. Von Vorteil ist dabei, dass der Kühlkörper einstückig oder mehrstückig ausführbar ist und somit abhängig von den jeweiligen Anforderungen geteilt oder einstückig ausführbar ist. Außerdem ist eine große Außenfläche um den Kühlkanal herum erreichbar, so dass eine effektive Entwärmung erreichbar ist.

Bei einer vorteilhaften Ausgestaltung sind ein oder mehrere Wärme erzeugende Bauelemente an einem jeweiligen Außenflächenabschnitt wärmeleitend verbunden. Von Vorteil ist dabei, dass durch die zentrale Belüftung eine große Außenfläche kühlbar ist. Insbesondere ist die Außenfläche aus mehreren ebenen Flächenabschnitten zusammensetzbar, so dass diesen Abschnitten ebene Leiterplatten zuordenbar sind und die darauf angeordneten Wärme erzeugenden Bauelemente mit dem jeweiligen Außenflächenabschnitt in Wärme leitenden Kontakt bringbar sind.

Bei einer vorteilhaften Ausgestaltung ist ein wärme erzeugendes Bauelement auf einer Leiterplatte bestückt, insbesondere wobei seine elektrischen Anschlusselemente lötverbunden sind mit einem Leiterbahnabschnitt,
wobei die Leiterplatte mittels einer Haltevorrichtung mit dem Kühlkörper verbunden ist. Von Vorteil ist dabei, dass die Haltevorrichtung auf der vom Kühlkörper abgewandten Seite der Leiterplatte anordenbar ist und nur beispielsweise schrauben durch die Leiterplatte hindurchführen zum Kühlkörper, so dass die Leiterplatte samt Bauelementen in Richtung auf den Kühlkörper zu drückbar ist.

Bei einer vorteilhaften Ausgestaltung ist die Haltevorrichtung ein auf die Leiterplatte Isoliermittel, welches von einer Halteplatte, insbesondere von einer metallischen Halteplatte, auf die Leiterplatte gedrückt ist,
insbesondere wobei die Halteplatte an den Kühlkörper angeschraubt oder von einem mit dem Kühlkörper schraubverbundenen Federelement an das Isoliermittel angedrückt ist. Von Vorteil ist dabei, dass hohe Kräfte auf die metallische und somit stabile Halteplatte einleitbar sind und die Andruckkraft somit über das Isoliermittel auf die Leiterplatte beziehungsweise die darauf bestückten Bauelemente weiterleitbar ist.

Bei einer vorteilhaften Ausgestaltung ist die Leiterplatte eine Anordnung aus mittels flexibler Bereiche verbundenen Leiterplatten,
insbesondere wobei die Anordnung den Kühlkörper in Umfangsrichtung des Kühlkanals zumindest teilweise umgibt. Von Vorteil ist dabei, dass eine Leiterplattenanordnung den Kühlkörper umgebend vorsehbar ist und somit eine große Leiterplattenfläche effektiv kühlbar ist, also mit geringem Bauvolumen.

Bei einer vorteilhaften Ausgestaltung ist am Kühlkörper zumindest ein Luftleitteil angeordnet,
insbesondere wobei ein erstes Luftleitteil einen Lüfter umfasst und ein von dem ersten Luftleitteil mittels des Kühlkörpers beabstandetes Luftleitteil zum Halten des Kühlkörpers an der Montageplatte dient, insbesondere wobei das weitere Luftleitteil zwischen dem Kühlkörper und der Montageplatte angeordnet ist. Von Vorteil ist dabei, dass die Luftführung verbessert ist und außerdem ein Luftleitteil zur mechanischen Befestigung verwendbar ist. Hierbei ist eine formschlüssige Verbindung, insbesondere in Umfangsrichtung um den Kühlkanal des Moduls herum, zwischen Kühlkörper und Luftleitteil einfach ausführbar, indem der Kühlkörper nicht einen kreisrunden, sondern einen polygonalen Querschnitt aufweist, also ebene Außenflächenabschnitte aufweist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist der Kühlkörper eines erfindungsgemäßen Moduls mit zentraler Belüftung in Schrägansicht gezeigt.
In der Figur 2 ist das Modul mit Leiterplattenabschnitten (23, 24, 25) gezeigt, auf welchen die Wärme erzeugenden elektronischen Bauelemente, insbesondere Leistungshalbleiter, bestückt sind.
In der Figur 3 ist eine zugehörige Schnittansicht gezeigt.
In der Figur 4 ist eine Schrägansicht eines mehrere solche Module aufnehmendes Gehäuses, insbesondere Schaltschrankgehäuses, gezeigt.
In der Figur 5 ist eine zugehörige Schnittansicht gezeigt.

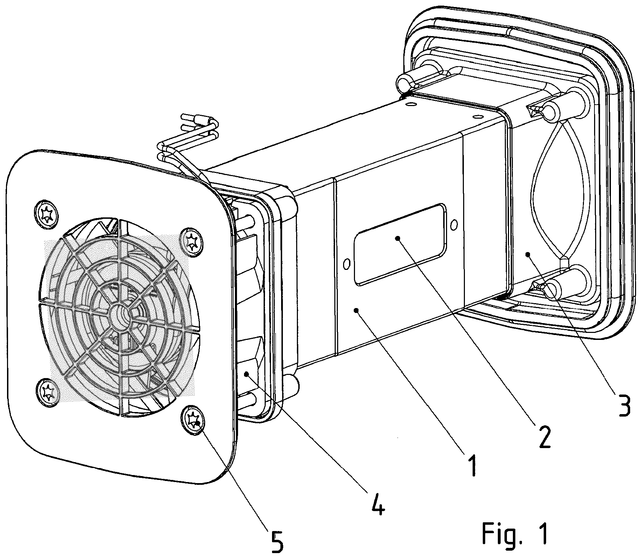

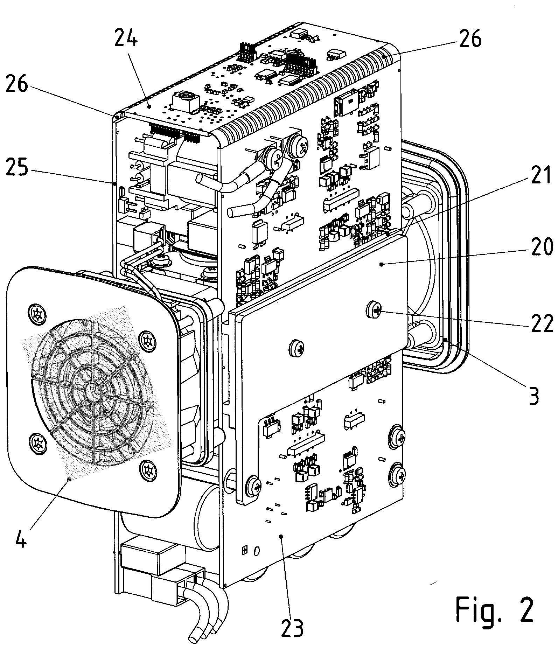

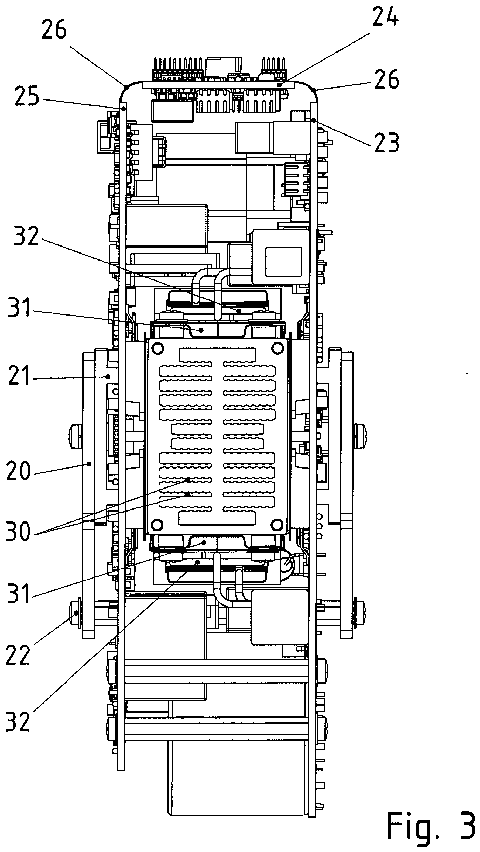

Wie in den Figuren 1 bis 3 gezeigt, weist das Modul eine zentrale Belüftung zum Entwärmen der von den Wärmeerzeugenden Bauelementen erzeugten Wärme auf. Hierzu ist ein Kühlkörper 1 vorgesehen, der als einstückig oder mehrstückig ausgeführtes Stranggussteil gefertigt ist.

Dieser Kühlkörper 1 ist hohl ausgeführt und weist in den Hohlraum hineinragende Kühlrippen 30 auf. Somit ist die Hohlraumoberfläche vergrößert und der Wärmeübergangswiderstand vom Kühlkörper 1 zum den Hohlraum durchströmenden Kühlmedium, insbesondere Kühlluft, verringert.

Da der Kühlkörper 1 ein Stranggussteil ist, insbesondere ein Aluminium-Stranggussteil, ist der Hohlraum durchgehend und die Kühlrippen 30 sowie der Hohlraum verlaufen in Stranggussrichtung.

Der Kühlkörper ist beispielhaft als Quader ausgeführt und weist somit vier in etwa ebene Seitenflächen auf. Zur Kontaktierung der Wärme erzeugenden Bauelemente weisen zumindest zwei Seitenflächen, insbesondere die zwei sich diametral gegenüberstehenden Seitenflächen, Kontaktflächen 2 auf, die fein bearbeitet sind, insbesondere also gefräst und/oder geschliffen und/oder sandgestrahlt oder dergleichen. Somit sind die Bauelemente an die Kontaktfläche andrückbar, insbesondere mit zwischengeordneter Wärmeleitpaste, und ein guter Wärmeübergang erreichbar.

An die beiden anderen Seitenflächen ist jeweils ein Ferritteil 31 angedrückt oder sonstig verbunden, so dass die von einer Wicklung 32 erzeugte Wärme über den Ferrit 31 an den Kühlkörper 1 leitbar ist. Dabei ist das Ferritteil 31 als Spulenkern der Wicklung 32 verwendet, so dass also das von der Wicklung 32 erzeugte Magnetfeld vom Ferritteil 31 gebündelt und geleitet wird.

Die Wicklung ist als Induktivität eines DC-DC Wandlers verwendet, also als Booster-Drossel eines DC-DC -Boosters.

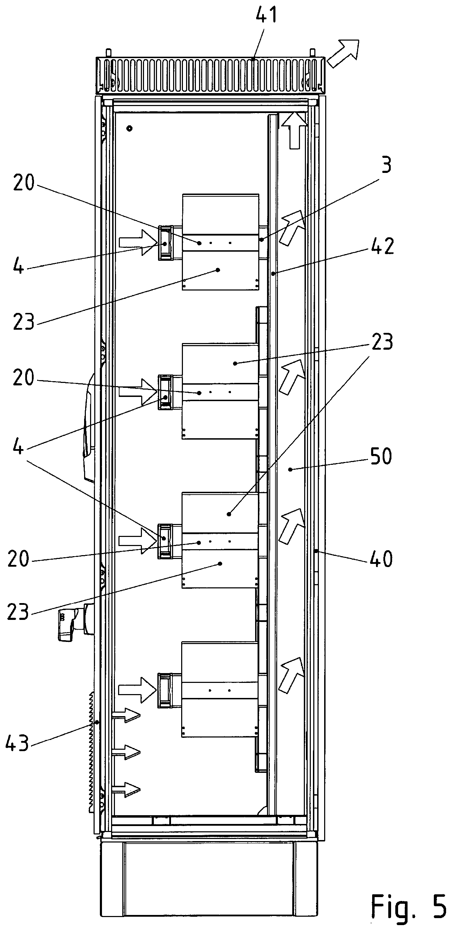

Der Hohlraum des Kühlkörpers 1 mündet an seiner ersten Öffnung in Stranggussrichtung in ein Luftleitteil 3, welches aus Kunststoff gefertigt ist und auf den Kühlkörper 1 aufgesteckt ist. Außerdem weist das Luftleitteil 3 an seinem von dem Kühlkörper 1 abgewandten Endbereich einen Flansch auf, mit dem es an einer Montageplatte 42 anschraubbar ist. Die Montageplatte 42 weist eine Ausnehmung auf, so dass das Kühlmedium nach Durchströmen des Kühlkörpers 1 und des Luftleitteils 3 die Ausnehmung der Montageplatte 42 durchströmt und in einen in Figur 5 gezeigten Luftkanal 50 einströmt.

Auf seinem von dem Luftleitteil 3 abgewandten Endbereich mündet der Hohlraum des Kühlkörpers 1 in ein Luftleitteil 4, in welchem ein Lüfter angeordnet ist.

Die Ferritteile 31 sind vorzugsweise schraubverbunden mit dem Kühlkörper 1 und somit angedrückt an diesen oder von einem mit dem Kühlkörper 1 schraubverbundenen Teil an den Kühlkörper 1 angedrückt.

Die Wärme erzeugenden Bauelemente sind auf einer der Leiterplatten (23, 25) bestückt. Diese Leiterplatten (23, 25) sind Teil einer flexiblen Leiterplattenanordnung. Hierbei sind die Leiterplatten (23, 24, 25) über zwischengeordnete flexible Bereiche 26 verbunden. Zur Herstellung dieser Leiterplattenanordnung wird von einer großen Leiterplatte das Trägermaterial, insbesondere Epoxidharz, in einem jeweiligen Teilbereich mechanisch herausgelöst, insbesondere herausgefräst, oder chemisch herausgelöst. Somit verbleiben in diesen nun als flexible Bereiche 26 fungierenden Teilbereichen nur noch die metallischen Leiterbahnen und eine jeweilige diese tragende Folie.

Die Leiterplattenanordnung sind somit um den Kühlkörper 1 herum gewunden, so dass die Wärme erzeugenden Bauelemente an den Kontaktflächen 2 der sich gegenüber angeordneten Außenflächen des Kühlkörpers 1 andrückbar sind.

Auf der zwischen den Leiterplatten (23, 25) zwischengeordneten Leiterplatte 24 ist die Induktivität eines DC-DC-Boosters angeordnet, deren Spulenkern, insbesondere Ferritteil 31, wärmeleitend verbunden, insbesondere angedrückt ist, an den Kühlkörper 1.

Auch auf der hierzu gegenüber angeordneten Außen-Seitenfläche ist eine ebensolche Induktivität eines oder des DC-DC-Boosters angeordnet, deren Spulenkern, insbesondere Ferritteil, wärmeleitend verbunden, insbesondere angedrückt ist, an den Kühlkörper 1.

Somit ist eine leistungsfähige Entwärmung der Wärme erzeugenden Bauelemente der elektronischen Schaltung erreicht. Insbesondere sind hierbei als Wärme erzeugende Bauelemente Leistungshalbleiterschalter und Spulenkerne der Wicklungen 32 beispielhaft erwähnt. Diese Wärme erzeugenden Bauelemente sind also jeweils auf der dem Kühlkörper 1 zugewandten Seite der jeweiligen Leiterplatte (23, 24, 25) angeordnet.

Mittels des Lüfters ist ein Kühlluftstrom antreibbar, so dass die Entwärmung sehr effektiv ausführbar ist. Aber auch ohne Lüfter ist eine konvektiv angetriebene Strömung vorhanden und bewirkt eine Entwärmung.

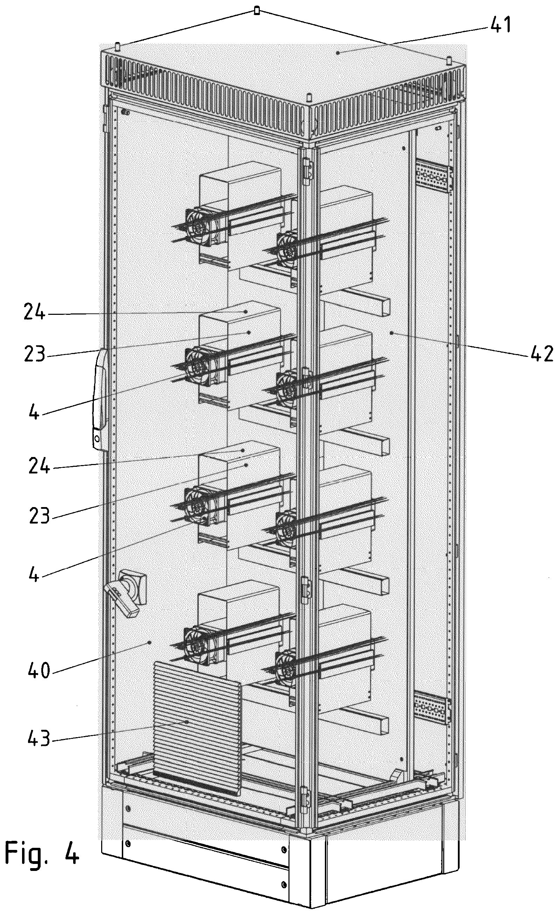

Wie in Figur 4 und 5 gezeigt, sind in einem Schaltschrank 40 mehrere wie in den Figuren 1 bis 3 zuvor beschriebene Module an einer Montageplatte 42 anordenbar, wobei die Montageplatte 42 zur zentralen Belüftung der jeweiligen Module eine jeweilige durchgehende Ausnehmung aufweist.

Somit mündet ein jeweiliger durch die Luftleitteile (3, 4) und den Hohlraum des Kühlkörpers 1 sowie durch die Ausnehmung in der Montageplatte 42 hindurchführender Kühlkanal in dem im Schaltschrank 40 vertikal hinaufführenden Luftkanal 50, welcher in ein Umlenkteil 41 mündet. Der Luftkanal 50 verläuft dabei innerhalb des Schaltschrankes 40. Das an der Oberseite des Schaltschrankes 40 angeordnete Umlenkteil weist eine zum Luftkanal 50 hin gerichtete Öffnung auf, die an einer an der Oberseite des Umlenkteils 41 angeordnete, horizontal verlaufende Grundplatte umgelenkt wird von der vertikalen in die horizontale Richtung.

Hierbei ist das Umlenkteil 41 vorzugsweise als Stranggussteil ausgeführt, so dass an der Grundplatte des Umlenkteils 41 Kühlrippen ausgeformt sind. Auf diese Weise gibt das vorbei strömende Kühlmedium Wärme ab an das Umlenkteil 41, welches dann zumindest auch an seiner Oberseite Wärme an die Umgebung, insbesondere Umgebungsluft, abführt.

Somit wird der Kühlluftstrom durch die Kühlkanäle der zentral belüfteten Module und durch die Montageplatte 42 geleitet, insbesondere in horizontaler Richtung bei vertikaler Ausrichtung der Montageplatte 42.

Die von den Lüftern in den Luftleitteilen 4 der Module angesaugte Luft wird von außen durch ein in der Gehäusewand des Schaltschrankes 40 vorgesehenes Lüftergitter 43 ins Gehäuseinnere geleitet und von dort von den Lüftern angesaugt.

Die Montageplatte 42 trennt also das Gehäuseinnere von dem Luftkanal 50 und somit die kühlere Luft von der wärmeren Abluft der Module.

Das jeweilige Modul ist mittels seines Luftleitteils 3 gehalten an der Montageplatte 42. Hierbei sind vorzugsweise an der der Montageplatte 42 zugewandten Seite Gewindebohrungen in dem Luftleitteil 3 eingebracht, so dass das Luftleitteil 3 mittels Schrauben an die Montageplatte anschraubbar ist. Bevorzugt gehen hierbei die Schrauben durch die Montageplatte 42.

Statt Luft ist auch ein anderes Kühlmedium verwendbar.

Mittels der zur Oberseite hin abdeckend wirksamen Grundplatte des Umlenkteils 41 ist ein Hereinfallen von Schmutzpartikeln in den Luftkanal 50 verhinderbar.

In der Figur 5 ist die Strömung des Kühlmediums durch Pfeile verdeutlicht.

In der Figur 4 sind die elektrischen Versorgungsleitungen, Datenbusleitungen und Ausgangsleitungen der Module mit jeweiligen schwarzen Linien angedeutet.

Somit ist in den Figuren 4 und 5 nun ein Schaltschrankgehäuse, in welchem eine Vielzahl von zentral belüfteten Modulen anordenbar und entwärmbar sind.

Die jeweiligen Module sind entweder alle gleichartig ausgeführt oder unterschiedlich zu zumindest einem der Module.

Die konkrete Ausführung nach Figur 1 bis 3 ist beispielhaft. Bei erfindungsgemäßen Ausführungsbeispielen ist wichtig, dass zentral im Modul ein hohler Kühlkörper, insbesondere Stranggussteil, angeordnet ist, an dessen Außenseite Wärme erzeugende Bauelemente wärmeleitend verbunden sind. Dabei sind diese Bauelemente auf derselben Leiterplatte bestückt oder jeweils auf separaten, also voneinander beabstandeten, miteinander nicht verbundenen Leiterplatten. Wenn die Leiterplatten miteinander verbunden sind, sind sie beispielhaft in der nach Figur 1 bis 3 gezeigten Weise verbunden, also über zwischengeordnete flexible Bereiche. Die Ausführung der flexiblen Bereiche als Teilbereiche einer ursprünglichen großen Leiterplatte, welche alle Leiterplatten des Moduls sowie die flexiblen Bereiche umfasst, ist nicht zwingend. Alternativ oder zusätzlich dürfen die flexiblen Bereiche nämlich auch als Gelenkteile ausgeführt werden, insbesondere also als Scharniere oder drehbare Verbindungselemente.

Bei einem weiteren erfindungsgemäßen Ausführungsbeispiel ist statt eines quaderförmigen, vier, in etwa ebene Außen-Seitenflächen aufweisenden Kühlkörpers ein polygonaler Kühlkörper verwendet, der drei, fünf, sechs oder mehr, in etwa ebene Außen-Seitenflächen aufweist.

Bei einem weiteren erfindungsgemäßen Ausführungsbeispiel ist statt des Schaltschrankgehäuses ein anderes Gehäuse verwendet, wobei statt des Lüftergitters 43 entweder eine Ausnehmung im Gehäuse anordenbar ist. Außerdem ist statt des Umlenkteils 41 auch ein anderes Luftleitteil verwendbar, beispielsweise ein Absaugrohr, welches mit dem Luftkanal 50 verbunden ist, oder ein Luftleitteil, das den Kühlluftstrom des Luftkanals 50 in eine andere Richtung lenkt.

### Bezugszeichenliste

1 Kühlkörper
2 Kontaktfläche
3 Luftleitteil
4 Luftleitteil
5 Schraube
20 Halteplatte, insbesondere metallisch
21 Isolierteil
22 Schraube
23 Leiterplatte
24 Leiterplatte
25 Leiterplatte
26 flexibler Bereich
30 Kühlrippen
31 Ferritteil
32 Wicklung
40 Schaltschrank
41 Umlenkteil
42 Montageplatte
43 Lüftergitter
50 Luftkanal

## Patentansprüche

1. **Schaltschrank (40)** mit Gehäuse,
wobei das Gehäuse mehrere Module gehäusebildend umgibt,
**wobei** jedes Modul zentral belüftet ist **und** einen von einem Kühlmedium durchströmten Kühlkörper (1) mit einem durchgehenden Hohlraum aufweist, welcher als Kühlkanal fungiert,
wobei die **als Kühlkanal ausgeführte** zentrale Belüftung jedes Moduls in einen innerhalb des Gehäuses angeordneten Sammelkanal mündet,
wobei der Sammelkanal zu einem **als Umlenkteil (41) ausgeführten** Luftleitteil des Gehäuses führt, wobei das Luftleitteil eine zur Umgebung hin gerichtete Öffnung aufweist,
wobei eine **Speisung der zentralen Belüftung aus einem von dem Gehäuse umgebenen Innenbereich** des Schatschranks (40) **erfolgt,**
**wobei das Gehäuse eine Ausnehmung aufweist, durch welche der Innenbereich mit einem Kühlmediumstrom speisbar ist,**
**wobei innerhalb des Gehäuses zwischen Innenbereich und Sammelkanal eine Montageplatte (42) angeordnet ist,**
**wobei der Innenbereich mittels der Montageplatte (42) vom Sammelkanal abgegrenzt ist** wobei jedes Modul ein erstes Luftleitteil (4) und ein von dem ersten Luftleitteil mittels des Kühlkörpers beabstandetes weiteres Luftleitteil (3) aufweist,
wobei das erste Luftleitteil (4) einen Lüfter umfasst und das weitere Luftleitteil (3) zum Halten des Kühlkörpers (1) an der Montageplatte (42) dient, wobei das weitere Luftleitteil (3) zwischen dem Kühlkörper (1) und der Montageplatte (42) angeordnet ist,
wobei die Module mit der Montageplatte (42) jeweils verbunden sind und das jeweilige Modul mittels seines Luftleitteils (3) an der Montageplatte (42) gehalten ist insbesondere wobei an der der Montageplatte (42) zugewandten Seite Gewindebohrungen in dem Luftleitteil (3) eingebracht sind, so dass das Luftleitteil (3) mittels Schrauben an die Montageplatte angeschraubt ist,
wobei die Montageplatte (42) eine dem jeweiligen Modul, zugeordnete, durch die Montageplatte (42) durchgehende Ausnehmung aufweist, zur Durchströmung mittels des Kühlmediumstroms.
wobei ein wärme erzeugendes Bauelement auf einer Leiterplatte (23, 24, 25) bestückt ist wobei seine elektrischen Anschlusselemente lötverbunden sind mit einem Leiterbahnabschnitt,
wobei die Leiterplatte (23, 24, 25) mittels einer Haltevorrichtung mit dem Kühlkörper (1) verbunden ist,
die Leiterplatte (23, 24, 25) eine Anordnung aus mittels flexibler Bereiche (26) verbundenen Leiterplatten (23, 24, 25) ist,
wobei die Anordnung den Kühlkörper (1) in Umfangsrichtung des Kühlkanals zumindest teilweise umgibt.

2. **Schaltschrank (40)** nach Anspruch 1, **dadurch gekennzeichnet, dass** jedes Luftleitteil (3, 4) als Stranggussteil gefertigt ist.

3. **Schaltschrank (40)** nach einem der vorangegangenen Ansprüche, **dadurch gekennzeichnet, dass**
der aus dem Sammelkanal ausströmende Kühlmediumstrom an Kühlrippen (30) entlang in die Umgebung herausgeleitet wird,
hierbei der Kühlmediumstrom umgelenkt wird, von einer im Wesentlichen vertikalen in eine im Wesentlichen horizontale Richtung.

4. **Schaltschrank (40)** nach einem der vorangegangenen Ansprüche, **dadurch gekennzeichnet, dass** jedes **Luftleitteil (3, 4) eine Grundplatte aufweist, an welcher dem Innenraum der Vorrichtung zugewandte Kühlrippen angeordnet sind,**

5. **Schaltschrank (40)** nach einem der vorangegangenen Ansprüche, **dadurch gekennzeichnet, dass** der Innenbereich durch zumindest die Montageplatte (42), das Gehäuse und das Lüftergitter (43) begrenzt ist und dass der Sammelkanal durch zumindest die Montageplatte (42) und das Gehäuse begrenzt ist.

6. **Schaltschrank (40)** nach einem der vorangegangenen Ansprüche, **dadurch gekennzeichnet, dass** der Kühlkörper (1) als Stranggussteil ausgeführt ist

7. **Schaltschrank (40)** nach einem der vorangegangenen Ansprüche, **dadurch gekennzeichnet, dass**
ein oder mehrere Wärme erzeugende Bauelemente an einem jeweiligen Außenflächenabschnitt wärmeleitend verbunden sind.

8. **Schaltschrank (40)** nach einem der vorangegangenen Ansprüche,
**dadurch gekennzeichnet, dass**
die Haltevorrichtung ein auf die Leiterplatte (23, 24, 25) Isoliermittel ist, welches von einer metallischen Halteplatte (20), auf die Leiterplatte (23, 24, 25) gedrückt ist,
wobei die Halteplatte (20) an den Kühlkörper (1) angeschraubt oder von einem mit dem Kühlkörper (1) schraubverbundenen Federelement an das Isoliermittel angedrückt ist.

## Claims

1. A control cabinet (40) with housing,
wherein the housing surrounds a plurality of modules in a housing-forming manner,
wherein each module is centrally ventilated and has a heat sink (1), through which a cooling medium flows, with a continuous cavity which functions as a cooling duct,
wherein the central ventilation means of each module, which is embodied as a cooling duct, opens into a collecting duct arranged within the housing,
wherein the collecting duct leads to an air-conducting part, embodied as a deflecting part (41), of the housing, wherein the air-conducting part has an opening directed towards the surroundings,
wherein feeding of the central ventilation means takes place from an inner region of the control cabinet (40) which is surrounded by the housing,
wherein the housing has a cutout through which the inner region can be fed with a cooling-medium stream,
wherein a mounting plate (42) is arranged within the housing between the inner region and collecting duct,
wherein the inner region is delimited from the collecting duct by means of the mounting plate (42), wherein each module has a first air-conducting part (4) and a further air-conducting part (3) which is spaced apart from the first air-conducting part by means of the heat sink,
wherein the first air-conducting part (4) comprises a fan and the further air-conducting part (3) serves to hold the heat sink (1) on the mounting plate (42), wherein the further air-conducting part (3) is arranged between the heat sink (1) and the mounting plate (42),
wherein the modules are connected in each case to the mounting plate (42) and the respective module is held on the mounting plate (42) by means of its air-conducting part (3),
in particular wherein threaded bores are formed in the air-conducting part (3) on that side which faces the mounting plate (42), so that the air-conducting part (3) is screwed to the mounting plate by means of screws,
wherein the mounting plate (42) has a cutout for the cooling-medium stream to flow through which is associated with the respective module and passes through the mounting plate (42),
wherein a heat-generating component is placed on a printed circuit board (23, 24, 25), wherein its electrical connection elements are connected by soldering to a printed conductor portion,
wherein the printed circuit board (23, 24, 25) is connected to the heat sink (1) by means of a holding device,
the printed circuit board (23, 24, 25) is an assembly of printed circuit boards (23, 24, 25) which are connected by means of flexible regions (26),
wherein the assembly at least partially surrounds the heat sink (1) in the peripheral direction of the cooling duct.

2. A control cabinet (40) according to claim 1,
**characterised in that**
each air-conducting part (3, 4) is manufactured as a continuously-cast part.

3. A control cabinet (40) according to one of the preceding claims,
**characterised in that**
the cooling-medium stream flowing out of the collecting duct is conducted out along cooling fins cooling fins [sic] (30) into the surroundings,
wherein in so doing the cooling-medium stream is deflected from a substantially vertical into a substantially horizontal direction.

4. A control cabinet (40) according to one of the preceding claims,
**characterised in that**
each air-conducting part (3, 4) has a base plate on which cooling fins which face the interior of the device are arranged.

5. A control cabinet (40) according to one of the preceding claims,
**characterised in that**
the inner region is limited by at least the mounting plate (42), the housing and the fan grille (43)
and **in that**
the collecting duct is limited by at least the mounting plate (42) and the housing.

6. A control cabinet (40) according to one of the preceding claims, **characterised in that**
the heat sink (1) is embodied as a continuously-cast part.

7. A control cabinet (40) according to one of the preceding claims, **characterised in that**
one or more heat-generating components is/are connected in a thermally conductive manner to a respective outer face portion.

8. A control cabinet (40) according to one of the preceding claims, **characterised in that**
the holding device is an insulating means [verb missing] onto the printed circuit board (23, 24, 25) which is pressed by a metallic holding plate (20) onto the printed circuit board (23, 24, 25),
wherein the holding plate (20) is screwed to the heat sink (1) or is pressed against the insulating means by a spring element which is screw-connected to the heat sink (1).

## Revendications

1. Armoire de commutation (40) munie d'un boîtier,
lequel boîtier entoure plusieurs modules avec formation d'un boîtier,
chaque module étant ventilé centralement, et étant pourvu d'un corps de refroidissement (1) parcouru par un agent de refroidissement et présentant une cavité ininterrompue remplissant la fonction d'un canal de refroidissement,
sachant que la ventilation centrale de chaque module, conçue en tant que canal de refroidissement, débouche dans un canal collecteur situé à l'intérieur du boîtier,
ledit canal collecteur menant à une partie de guidage d'air équipant le boîtier et conçue en tant que partie déflectrice (41), laquelle partie de guidage d'air est dotée d'une ouverture dirigée vers l'espace environnant,
sachant qu'une alimentation de ladite ventilation centrale s'opère à partir d'une zone intérieure de l'armoire de commutation (40), entourée par le boîtier,
lequel boîtier présente un évidement à travers lequel ladite zone intérieure peut être alimentée par un flux d'agent de refroidissement,
un panneau de montage (42) étant interposé entre la zone intérieure et le canal collecteur, à l'intérieur dudit boîtier,
ladite zone intérieure étant démarquée dudit canal collecteur au moyen dudit panneau de montage (42), chaque module comprenant une première partie (4) de guidage d'air et une partie additionnelle (3) de guidage d'air qui est tenue à distance de ladite première partie de guidage d'air au moyen du corps de refroidissement,
sachant que ladite première partie (4) de guidage d'air inclut un ventilateur, et que ladite partie additionnelle (3) de guidage d'air sert à retenir le corps de refroidissement (1) sur le panneau de montage (42), laquelle partie additionnelle (3) de guidage d'air est interposée entre ledit corps de refroidissement (1) et ledit panneau de montage (42),
les modules étant respectivement reliés au panneau de montage (42), et le module considéré étant retenu sur ledit panneau de montage (42) au moyen de sa partie (3) de guidage d'air,
sachant notamment que des perçages taraudés sont pratiqués dans ladite partie (3) de guidage d'air, du côté pointant vers ledit panneau de montage (42), de telle sorte que ladite partie (3) de guidage d'air soit rapportée par vissage sur ledit panneau de montage, au moyen de vis,
lequel panneau de montage (42) est nanti d'un évidement associé au module respectif et traversant ledit panneau de montage (42) de part en part, en vue de l'irrigation traversante au moyen du flux d'agent de refroidissement,
sachant qu'un élément structurel générateur de chaleur est implanté sur une plaquette (23, 24, 25) à circuits imprimés, ses éléments de connexion électrique étant alors raccordés par brasage à un segment de piste conductrice,
ladite plaquette (23, 24, 25) à circuits imprimés étant reliée au corps de refroidissement (1) au moyen d'un dispositif de retenue,
laquelle plaquette (23, 24, 25) à circuits imprimés est un ensemble de plaquettes (23, 24, 25) à circuits imprimés reliées au moyen de régions flexibles (26),
ledit ensemble ceinturant, au moins partiellement, le corps de refroidissement (1) dans la direction périphérique du canal de refroidissement.

2. Armoire de commutation (40) selon la revendication 1,
**caractérisée par le fait que**
chaque partie (3, 4) de guidage d'air est produite en tant que pièce venue de coulée continue.

3. Armoire de commutation (40) selon l'une des revendications précédentes, **caractérisée par le fait que**
le flux d'agent de refroidissement sortant du canal collecteur est canalisé extérieurement vers l'espace environnant, le long d'ailettes de refroidissement (30),
ledit flux d'agent de refroidissement étant alors dévié d'une direction sensiblement verticale vers une direction sensiblement horizontale.

4. Armoire de commutation (40) selon l'une des revendications précédentes, **caractérisée par le fait que**
chaque partie (3, 4) de guidage d'air est pourvue d'une platine d'embase sur laquelle sont placées des ailettes de refroidissement tournées vers l'espace interne du dispositif.

5. Armoire de commutation (40) selon l'une des revendications précédentes, **caractérisée par le fait que**
la zone intérieure est délimitée au moins par le panneau de montage (42), par le boîtier et par la grille (43) du ventilateur ;
et **par le fait que**
le canal collecteur est délimité au moins par ledit panneau de montage (42) et par ledit boîtier.

6. Armoire de commutation (40) selon l'une des revendications précédentes, **caractérisée par le fait que**
le corps de refroidissement (1) est réalisé en tant que pièce venue de coulée continue.

7. Armoire de commutation (40) selon l'une des revendications précédentes, **caractérisée par le fait**
**qu'**un ou plusieurs élément(s) structurel(s) générateur(s) de chaleur est (sont) relié(s), de manière thermiquement conductrice, au niveau d'un tronçon respectif de surface extérieure.

8. Armoire de commutation (40) selon l'une des revendications précédentes, **caractérisée par le fait que**
le dispositif de retenue est un moyen isolant, sur la plaquette (23, 24, 25) à circuits imprimés, qui est pressé sur ladite plaquette (23, 24, 25) à circuits imprimés par une platine métallique de maintien (20),
ladite platine de maintien (20) étant rapportée par vissage sur le corps de refroidissement (1), ou bien pressée sur ledit moyen isolant par un élément élastique relié par vissage audit corps de refroidissement (1).
